**Europäisches Patentamt**

**European Patent Office**

**Office européen des brevets**

(19)

(11) Veröffentlichungsnummer: **0 487 941 A2**

## (12) EUROPÄISCHE PATENTANMELDUNG

(21) Anmeldenummer: **91118772.2**

(22) Anmeldetag: **04.11.91**

(51) Int. Cl.5: **G06F 11/26**

(30) Priorität: **30.11.90 DE 4038323**

(43) Veröffentlichungstag der Anmeldung:
**03.06.92 Patentblatt 92/23**

(84) Benannte Vertragsstaaten:
**AT CH DE ES FR GB IT LI NL SE**

(71) Anmelder: **SIEMENS AKTIENGESELLSCHAFT**
**Wittelsbacherplatz 2**
**W-8000 München 2(DE)**

(72) Erfinder: **Zepp, Claus-Peter, Dipl.-Ing.**
**Portweg 1a**
**W-8000 München 45(DE)**
Erfinder: **Knier, Hans-Josef, Dipl.-Ing.**
**Ministerhügel 10**
**W-8134 Pöching(DE)**

(54) **Prüfbare integrierte Schaltung und Schaltungsbaugruppe.**

(57) Die für Boundary-Scan-Prüfung ausgelegten integrierten Schaltungen (IC) weisen Eingangs-Prüfstufen (EPS) und Ausgangs-Prüfstufen (APS) mit einer minimalen Anzahl von logischen Elementen und somit einer geringen Laufzeit auf. Das Eingangsmode-Steuersignal (MS1) und das Ausgangsmode-Steuersignal (MS2) sind auf getrennte Anschlußpunkte geführt, wodurch ein Controller entfallen kann.

Durch die Prüfstufen wird eine hohe Frequenz des Prüftaktsignals (TC) bei minimalen Schaltungsaufwand möglich.

FIG 1

Die Erfindung betrifft Schaltungsbaugruppen und integrierte Schaltungen für das sogenannte Boundary-Scan-Prüfverfahren.

Bei diesem Prüfverfahren weisen die integrierten Schaltungen an logischen Eingängen und logischen Ausgängen Prüfstufen (Boundary Scan cells) auf, die zwischen den Anschlußpunkten und der Funktionslogik angeordnet sind. Die Eingangsprüfstufen und die Ausgangsprüfstufen bilden eine Schieberegisterkette um den logischen Baustein (seine Grenze = Boundary) herum. Da in der Regel mehrere integrierte Schaltkreise auf einer Baugruppe angeordnet sind, werden ihre Prüfstufen in Kette geschaltet. Das Boundary-Scan-Prüfverfahren ist in der Zeitschrift Elektronik in einer Fortsetzungs-Artikelserie in den Heften 12 (Seiten 52-57) / 13 (Seiten 102-108) / 14 (Seiten 96-103 ) / 15 (Seite 69-74) und 17 (Seiten 62-68) 1989 beschrieben.

In Heft 17, S. 67, Bild 5 ist eine Baugruppe mit zwei integrierten Schaltungen dargestellt und das Prüfverfahren im Begleittext beschrieben. Mit diesem Prüfverfahren lassen sich vor allen Dingen die Verbindungsleitungen von der Steckerleiste der Baugruppe zu den Anschlüssen der integrierten Bausteine und zwischen den integrierten Bausteinen überprüfen; ebenso können die Funktionen der logische Bausteine überprüft werden. Das Boundary-Scan-Verfahren hat den Vorteil, daß nur wenige zusätzliche Anschlußpunkte bei den integrierten Schaltungen und auf der Baugruppe vorgesehen werden müssen. In Heft 14, Seite 97, Bild 2 ist die Anordnung der Prüfstufen (Scope ≙ boundary- scan cell) dargestellt. Für Testzwecke können die Prüfzellen gesteuert werden. Diese Steuerung erfolgt über eine mit JTAG-Control bezeichnete Steuereinrichtung, die aus einem seriellen Steuersignal TMS mehrere parallele Steuersignale erzeugt. Dies hat den Vorteil, daß insgesamt nur vier zusätzliche Anschlußpunkte: für die eingegebene Prüfinformation TDI, die ausgegebene Prüfinformation TDO, für die Steuerinformation TMS und den Prüftakt TC benötigt werden. Im IEEE Standard 1149.1 "Standard Test Access, Port and Boundary-Scan Architecture, November 25, 1988" wurden bereits Bedingungen für die Durchführung des Test und Schaltungen für die Testlogik vorgeschlagen. Hier sind auch Eingangsprüfzellen (S. 8-7 und 8-8 ) und Ausgangsprüfzellen (S. 8-9 und 8-11) sowie auch Prüfzellen für Tri-State-Anschlüsse (S. 8-13) vorgeschlagen. Verwendet wurden bisher meist kompliziertere Prüfstufen, die eine weitgehend unabhängige Handhabung der seriell eingegebenen Prüfinformation von den an den Ein- und Ausgängen der integrierten Schaltkreise anliegenden logischen Zuständen ermöglicht. Diese Prüfstufen haben jedoch den Nachteil, daß sie relativ aufwendig sind und in den Signalwegen liegen.

Außerdem ist in jedem Baustein eine Steuerung erforderlich, die einen erheblichen zusätzlichen Schaltungsaufwand mit sich bringt.

Aufgabe der Erfindung ist es daher, integrierte Schaltungen und Baugruppen für das Boundary-Scan-Prüfverfahren anzugeben, die ein Testen mit einer maximalen Geschwindigkeit ermöglichen und bei denen der zusätzlichen Schaltungsaufwand auf ein Minimum reduziert ist.

Die in den unabhängigen Ansprüchen angegebenen integrierten Schaltkreise benötigen nur einen minimalen Schaltungsmehraufwand für Prüfzwecke und weisen in den Datenleitungen nur eine minimale Anzahl von zusätzlichen Schaltungselementen auf.

In den Verbindungsleitungen zwischen Eingangs-Anschlußpunkten und Funktionslogik einer integrierten Schaltung wird kein weiteres Schaltungselement eingefügt. Die Prüfstufen werden zweckmäßigerweise nach der Bond-Verbindung angeschaltet. Schutzschaltungen oder Trennverstärker können hierbei noch vor der Eingangs-Prüfstufe liegen. Ebenso kann die Ausgangs-Prüfstufe noch vor einem Ausgangsverstärker oder/und Schutzschaltungen angebracht sein. In der Ausgangs-Verbindungsleitung liegt nur ein einziger Multiplexer, so daß die Signallaufzeit nur geringfügig verzögert wird. Die Speicherstufen der Ausgangs-Prüfstufen sind direkt ohne weitere Logikelemente zu einem Schieberegister zusammengeschaltet.

Besonders vorteilhaft ist die getrennte Steuerung der Multiplexer der Eingangs-Prüfstufen und der Ausgangs-Prüfstufen. Eine Steuerung (Controller) wird in der integrierten Schaltung dann nicht benötigt, da die Information an den Datenausgängen der Ausgangs-Prüfstufen ständig entsprechend dem Prüfdatensignal TDI wechselt, wird durch eine Trennung der Steuerleitungen bzw. der Steuersignale für die eingangsseitige und ausgangsseitige Schieberegisterkette erreicht, daß wahlweise nur die von der Funktionslogik ausgegebenen Daten an den Ausgängen der Ausgangs-Prüfstufen und damit der Anschlußpunkte des integrierten Bausteines angegeben werden.

Bei bidirektionalen Anschlüssen der integrierten Bausteine wird eine Kombination der verwendeten Eingangs-Prüfstufen und Ausgangs-Prüfstufen verwendet. Diese weisen zusätzlich noch einen Steuerteil auf, um ebenfalls die Richtung des Datenflusses über eine Tri-State-Ausgangsstufe steuern zu können. Hierzu ist allerdings ein weiterer Anschlußpunkt der integrierten Schaltung erforderlich. Bei einem Datenbus werden die zugehörigen Ausgangsstufen durch einen gemeinsamen Steuerteil gesteuert.

Vorteilhaft ist es, wenn beide Steuerleitungen auch auf die Steckerleiste oder eine separate Prüfsteckerleiste der Baugruppe herausgeführt wird. Auf die eine Steuerung (Controller) auf der Baugruppe kann dann verzichtet werden. Selbstverständlich kann auch der bisher benötigte Controller auf der Baugruppe wieder eingesetzt werden, der dann den Prüfvorgang bei allen integrierten Bausteinen steuert. Hierdurch wird ein Anschlußpunkt bzw. zwei Anschlußpunkte bei der Baugruppe eingespart.

Vorteilhafte Ausbildungen der Erfindung sind in den übrigen Unteransprüchen angegeben.

Ausführungsbeispiele der Erfindung werden anhand von Figuren näher erläutert.

Es zeigen:

Fig. 1　　eine integrierte Schaltung auf einer Baugruppe,

Fig. 2　　eine Eingangs-Prüfstufe,

Fig. 3　　eine Ausgangs-Prüfstufe,

Fig. 4　　ein Verdrahtungsschema für die Prüfstufen,

Fig. 5　　eine Prüfstufe für bidirektionelle Anschlüsse,

Fig. 6　　ein Verdrahtungsschema für diese Prüfstufen und

Fig. 7　　eine Baugruppe mit einem Controller.

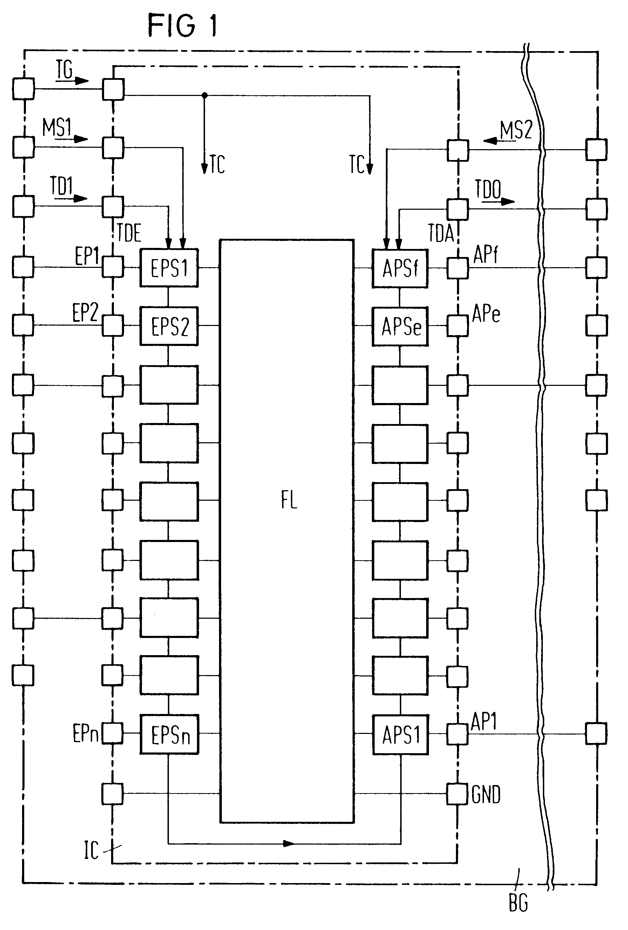

In Figur 1 ist eine integrierte Schaltung IC auf einer Baugruppe BG dargestellt. Der integrierte Baustein IC weist eine Funktionslogik FL auf, in der die logischen Verknüpfungen hergestellt werden, die zur Realisierung einer gewünschten Funktion erforderlich sind. Bei der Funktionslogik kann es sich sowohl um eine Verknüpfung von logischen Gattern handeln, ebenso kann es sich um eine Verknüpfung von Speicherstufen mit Gattern, um reine Speicherstufen oder auch um Mikroprozessoren und so weiter handeln. Zwischen den Eingangs-Anschlußpunkten (pins) EP1, EP2, ... EPn des integrierten Bausteines und Eingängen der Funktionslogik sind Eingangs-Prüfstufen (scan input cells) EPS1 bis EPSn angeschaltet. Ebenso sind zwischen Ausgängen der Funktionslogik FL und Ausgangs-Anschlußpunkten AP1 bis APf Ausgangs-Prüfstufen (scan output cells) APS1 bis APSf eingeschaltet. Die Stufen der Speicherstufen EPS1 bis APSf sind in Kette schaltbar und bilden dann ein Schieberegister. Der ersten Eingangs-Prüfstufe EPS1 wird ein Prüfdatensignal TDI über einen Prüfdaten-Eingang TDE zugeführt. Die Prüfdaten können sämtliche Prüfstufen durchlaufen und beispielsweise unverändert am Prüfdatenausgang TDA der letzten Ausgangs-Prüfstufe APSf als Ausgangs-Prüfdatensignal TDO ausgegeben werden. In den Prüfstufen werden die Prüfdaten mit einem Prüftaktsignal TC getaktet. Die Eingangs-Prüfstufen und die Ausgangs-Prüfstufen sind über Steuersignale MS1 bzw. MS2 separat steuerbar.

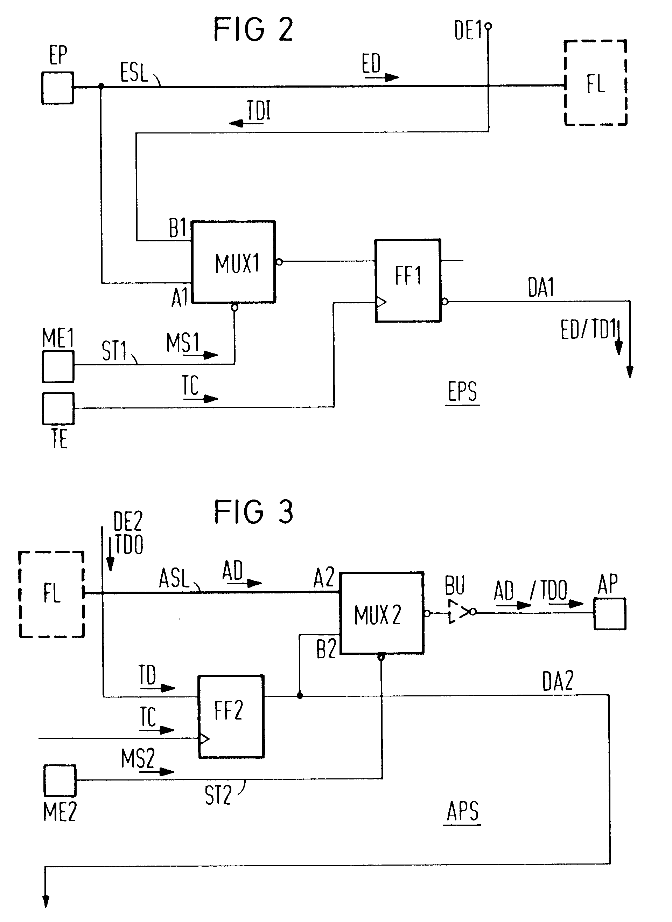

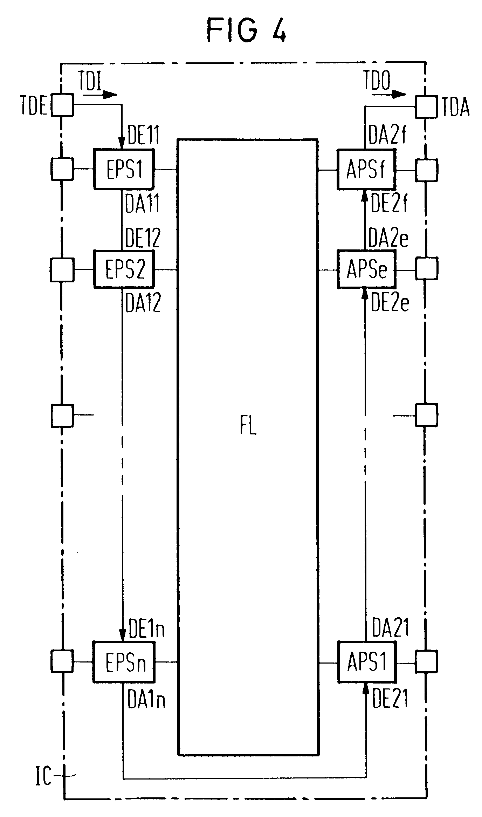

In Figur 2 ist eine Eingangs-Prüfstufe EPS detailliert dargestellt. Ein Eingangs-Anschlußpunkt (pin) EP ist direkt mit der Funktionslogik FL über eine Verbindungsleitung ESL verbunden. An diese Verbindungsleitung (nach der Bondleitung und gegebenenfalls Schutzschaltungen oder/und Eingangspuffern) ist der erste Eingang A1 eines Eingangs-Multiplexers MUX1 angeschaltet. Über diesen Eingang können Eingangsdaten ED an den Multiplexerausgang durchgeschaltet werden. Der zweite Multiplexereingang B1 stellt den Dateneingang DE1 für das Prüfdatensignal TDI dar. Der Ausgang des Multiplexers ist mit dem Dateneingang einer Eingangs-Speicherstufe FF1, beispielsweise einer D-Kippstufe, verbunden. Ein Ausgang dieser Kippstufe stellt den Datenausgang DA1 dar. Der Eingangs-Multiplexer wird über eine erste Steuerleitung ST1 von einem an einem ersten Steuereingang ME1 anliegenden Eingangsmode-Steuersignal MS1 gesteuert, so daß wahlweise der Anschlußpunkt EP (MS1 = log. 0) oder der Dateneingang DE1 (MS1 = log. 1) auf den Dateneingang der Eingangs-Speicherstufe FF1 schaltbar ist. Der Eingangs-Speicherstufe FF1 wird außerdem das Prüftaktsignal TC über einen Takteingang TE zugeführt. Der Datenausgang DA1 der ersten Eingangs-Prüfstufe wird mit dem Dateneingang DE1 (DE12) der zweiten Prüfstufe verbunden und so weiter, wie dies aus Figur 4 entnehmbar ist. Die Dateneingänge und Datenausgänge sind entsprechend der Nummerierung der Eingangs-Prüfstufen mit einer weiteren Ziffer versehen.

Bevor auf die Funktion der Eingangs-Prüfstufen näher eingegangen wird, soll erst eine Ausgangs-Prüfstufe beschrieben werden.

In Figur 3 ist eine Ausgangs-Prüfstufe APS dargestellt. Die Funktionslogik FL ist mit einem ersten Eingang A2 eines Ausgangs-Multiplexers MUX2 verbunden, dessen Ausgang auf einen Ausgangs-Anschlußpunkt (pin) AP geführt ist. Einem zweiten Eingang B2 des Ausgangs-Multiplexers MUX2 ist eine Ausgangs-Speicherstufe FF2 vorgeschaltet, deren Dateneingang mit DE2 und deren Datenausgang mit DA2 bezeichnet ist. Die Ausgangs-Speicherstufe wird ebenfalls von dem Prüftaktsignal TC getaktet.

Über einen zweiten Steuereingang ME2 und eine zweite Steuerleitung ST2 ist der Ausgangs-Multiplexer MUX2 durch ein Ausgangsmode-Steuersignal MS2 umschaltbar. Wahlweise können Ausgangsdaten AD von der Funktionslogik FL (MS2 = log. 0) oder das Prüfdatensignal TDO (MS2 = log. 1) an den Ausgangs-Anschlußpunkt AP durchgeschaltet werden. In die Verbindungsleitung ASL zwischen Funktionslogik FL und Ausgangs-Anschlußpunkt AP ist nur der Ausgangs-Multiplexers MUX2 zusätzlich eingeschaltet. Natürlich kann auch noch ein Ausgangsverstärker (Buffer) oder eine Schutzschaltung zwischen dem Ausgang des Ausgangs-Multiplexers und dem Anschlußpunkt bzw. der Bondleitung eingeschaltet sein.

Der Dateneingang DE2 der ersten Ausgangs-Prüfstufe ist an den Datenausgang DA1 (DA1n in Fig. 4) der letzten Eingangs-Prüfstufe EPSn angeschaltet. Bei den übrigen Ausgangs-Prüfstufen ist jeweils ein Dateneingang DE2 der folgenden Ausgangs-Prüfstufe an den Datenausgang DA2 der vorhergehenden Ausgangs-Prüfstufe angeschlossen, wie dies ebenfalls aus Figur 4 hervorgeht. Auch hier sind entsprechend der Nummerierung der Ausgangs-Prüfstufen die Dateneingänge und Datenausgänge jeweils mit einer zweiten Ziffer versehen.

Aus Figur 4 ist in Verbindung mit den Figuren 2 und 3 ersichtlich, daß die Eingangs-Speicherstufe FF1 der letzten Eingangs-Prüfstufe oder die Ausgangs-Speicherstufe FF2 der ersten Ausgangs-Prüfstufe entfallen kann.

Die Speicherstufen FF1 der Eingangs-Prüfstufen können einmal die an den Eingangs-Anschlußpunkten EP anliegende Eingangs-Information ED parallel übernehmen.

Diese kann dann durch Bildung eines Schieberegisters durch Steuerung über das Eingangsmode-Steuersignal MS1 über die Ausgangs-Speicherstufen FF2 der Ausgangsprüfstufen seriell ausgegeben und ausgewertet werden.

Durch Anlegen von 01-Folgen an die Eingangs-Anschlußpunkte EP werden die Verbindungsleitungen auf Unterbrechung und Kurzschluß überprüft.

Über den Prüfdateneingang TDE können beliebige Prüfdaten TDI über die Eingangs-Prüfstufen in die Speicherstufen FF2 der Ausgangs-Prüfstufen eingegeben werden. Diese bilden immer ein Ausgangs-Schieberegister, dessen durchgeschobene Information stets am Prüfdatenausgang TDA seriell ausgegeben wird. Die Ausgangs-Prüfinformation ist mit TDO bezeichnet; sie kann mit dem durchgeschobenen Prüfdatensignal TDI übereinstimmen aber auch, wie vorstehend beschrieben, durch die Eingangsdaten ED gebildet werden.

Über die Eingangs-Anschlußpunkte EP können unterschiedliche Eingangskombinationen an die integrierte Schaltung und damit an die Eingänge der Funktionslogik FL angelegt werden, deren Funktion anhand der an den Ausgangs-Anschlußpunkten AP abgegebenen Ausgangsdaten AD überprüft wird. Sind die Ausgangs-Anschlußpunkte auf die Steckerleiste der Baugruppe geführt, ist hier auch eine Überprüfung direkt möglich. Sind die Ausgangs-Anschlußpunkte AP des integrierten Bausteines dagegen auf Eingänge eines oder mehrerer integrierter Bausteine geführt, so können die anliegenden logischen Daten wiederum über deren Eingangs- und Ausgangs-Prüfschaltungen getestet werden.

Die Ausgangs-Prüfdaten TDO werden vom Ausgang der Speicherstufe FF1 der letzten Eingangsprüfstufe ständig in das Ausgangs-Schieberegister (alle Speicherstufen FF2) übernommen und ausgegeben. Wenn die Ausgangs-Multiplexer MUX2 die Ausgangsdaten AD durchschalten, stören sie jedoch nicht. So kann die Funktionslogik überprüft werden und gleichzeitig können bereits Prüfdaten in das Ausgangs-Schieberegister übernommen werden.

Diese werden zum Überprüfen der angeschlossenen Leitungen auf die Ausgangs-Anschlußpunkte AP durchgeschaltet. Sind diese mit Anschlußpunkten der Steckerleiste der Baugruppe verbunden, können sie direkt überprüft werden, sonst müssen - wie bei der Überprüfung der Funktionslogik - sie über die Eingangs-Prüfstufe der angeschlossenen Bausteine in die Eingangs-Speicherstufen FF1 zunächst eingelesen und nach der Ausgabe des Prüfdatensignals TDO bewertet werden. Wenn als Prüfdateninformation TDI eine 0101-Folge, 0011-Folge usw. gewählt wird, können auch an den Ausgangs-Anschlußpunkten AP angeschaltete analoge Bauelemente, beispielsweise Übertrager mit überprüft werden.

Bei den gewählten Eingangs-Prüfstufen ist es nicht möglich, beliebige Prüfdaten TDI über den Prüfdateneingang TDE an die Eingangs-Anschlußpunkte ED anzulegen. Sie eignen sich daher besonders zur Überprüfung der Verbindungsleitungen auf der Baugruppe und der Lötstellen der integrierten Schaltungen.

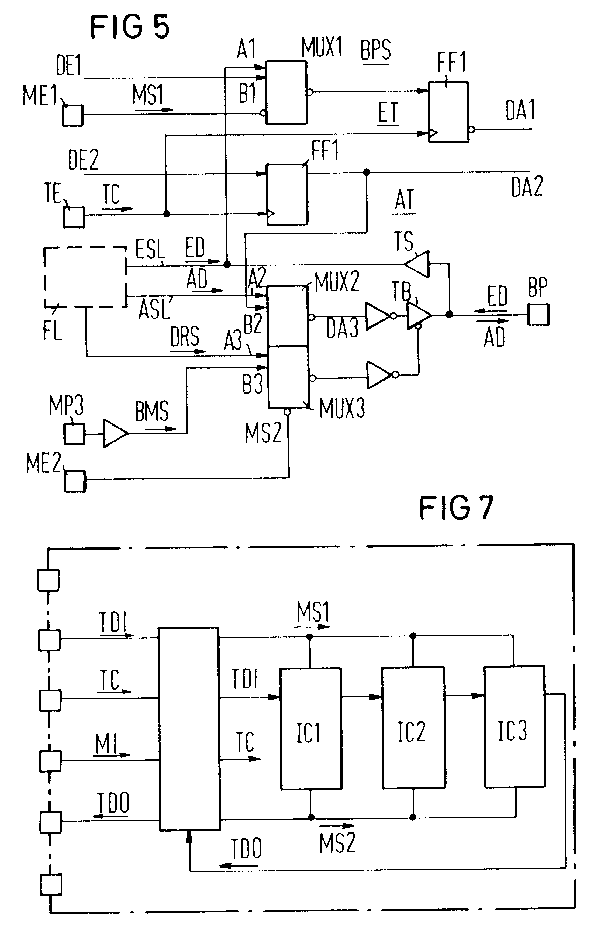

In Figur 5 ist eine Prüfstufe für bidirektionale Anschlußpunkte BP dargestellt. Sie ist eine Kombination aus Eingangs-Prüfstufe und Ausgangs-Prüfstufe. Deshalb sind die Bezeichnungen für die Bauelemente, die Dateneingänge und Datenausgänge beibehalten worden. Der Eingangsteil ET mit dem Eingangs-Multiplexer MUX1 und der Eingangs-Speicherstufe FF1 entspricht einer Eingangs-Prüfstufe; der Ausgangsteil AT mit der Ausgangs-Prüfstufe FF2 und dem Ausgangs-Multiplexer MUX2 entspricht einer Ausgangs-Prüfstufe. Der Datenausgang DM2 dieses Multiplexers ist über eine Tri-State-Stufe TB auf den Anschlußpunkt BP geführt, der über einen Trennverstärker TS mit der Verbindungsleitung ESL der Funktionslogik FL und dem ersten Eingang A1 des Eingangs-Multiplexers MUX1 verbunden ist. Wie bisher ist eine Ausgangs-Verbindungsleitung ASL mit dem ersten Eingang des Ausgangs-Multiplexers MUX2 (≙ dem Ausgangs-Multiplexers MUX2 einer Ausgangs-Prüfstufe) verbunden. Ein dritter Multiplexer MUX3 arbeitet als Steuerteil, das die Tri-State-Stufe TB aktiv oder hochohmig schaltet. Dem ersten Eingang A3 dieses Multiplexers wird ein Richtungssignal DRS von der Funktionslogik zugeführt, während an dem zweiten Eingang B3 über einen dritten Steuereingang MP3 ein externes Richtungssignal BMS anliegt. Die Multiplexer MUX2 und MUX3 werden durch das Ausgangs-Mode-Steuersignal MS2 geschaltet. Bei normalem Betrieb (MS2 = log. 1) erfolgt die Richtungssteuerung durch das Datenrichtungssignal DRS der Funktionslogik FL. Werden dagegen die in den Ausgangs-Speicherstufen FF2 vorhandenen Daten über den Ausgangs-Multiplexer MUX2 durchgeschaltet (MS2 = log. 0) so erfolgt die Richtungssteuerung über das externe Richtungssignal BMS (z.B. BMS = log. 1: TB auf Tri-State). Durch die getrennten Eingangsmode- und Ausgangsmode-Steuersignale MS1 und MS2 sind wiederum alle Prüfmöglichkeiten gegeben.

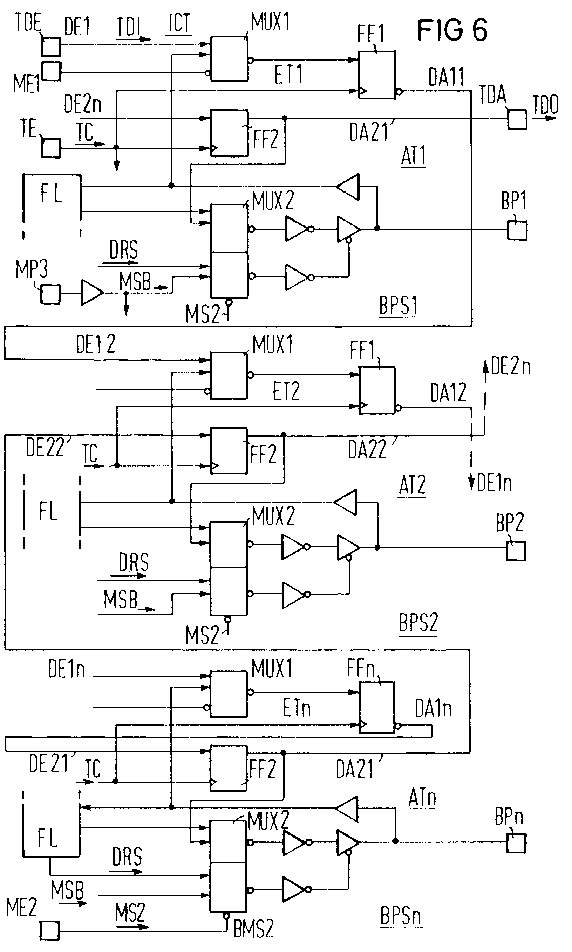

In Figur 6 ist die Verdrahtung von bidirektionalen Prüfstufen dargestellt. Die Verdrahtung der Eingangsteile ET1 bis ETn erfolgt in der üblichen Weise, bei der der Datenausgang DA11 des ersten Eingangsteils ET1 mit dem Dateneingang DE12 des zweiten Eingangsteils verbunden ist usw. Der Datenausgang DA1n des letzten Eingangsteiles ETn ist mit dem Dateneingang DE21 des ersten Ausgangsteiles AT1 verbunden. Dieser kann im Prinzip beliebig gewählt werden und ebenso in der ersten bidirektionalen Prüfstufe BPS1 als auch in der letzten bidirektionalen Prüfstufe BPSn positioniert sein, wie dies in Figur 6 der Fall ist. Ein Datenausgang DA2 eines Ausgangsteils AT1 wird mit dem Dateneingang DE22 des nächsten Ausgangsteils AT2 verbunden und so weiter bis der Datenausgang DA2n auf dem Prüfdatenausgang TDA der integrierten Schaltung geführt wird. Funktionsmäßig entspricht die bidirektionale Prüfstufe einer Eingangs- und einer Ausgangsprüfstufe, davon abgesehen, daß über einen Anschlußpunkt Daten nur eingegeben oder ausgegeben werden können. In der Regel sind bidirektionale Anschlußpunkte und zumindest Eingangs-Anschlußpunkte auf einen IC vorhanden. In einem solchen Fall können unterschiedliche Prüfstufen verwendet werden. Ebenso können bipolare Prüfstufen nur teilweise funktionell genutzt werden. Eingangs-Prüfstufen, Ausgangs-Prüfstufen und bidirektionale Prüfstufen (deren Eingangsteile und Ausgangsteile) können in Kette geschaltet werden.

In Figur 7 ist eine Variante einer prüfbaren Schaltungsbaugruppe dargestellt, bei der ein bisher üblicher Controller COT vorgesehen ist. Dieser steuert sämtliche integrierten Schaltungen IC1, IC2, IC3 und muß daher nur einmal vorhanden sein. Die Steuerinformation TMI kann wie bisher bei herkömmlichen prüfbaren Baugruppen seriell in den Controller eingegeben werden, wodurch ein oder zwei Prüfpunkte (bei bidirektionalen Prüfstufen) eingespart werden.

**Patentansprüche**

1.   Prüfbare integrierte Schaltung (IC), bei der zwischen Eingangs-Anschlußpunkten (EP1, EP2, ...) und Funktionslogik (FL) jeweils eine Eingangs-Prüfstufe (EPS; EPS1, EPS2,...) angeordnet ist, die einen Eingang-Multiplexer (MUX1) und eine nachgeschaltete Eingangs-Speicherstufe (FF1) aufweist, wobei der erste Eingang (A1) des Eingangs-Multiplexers (MUX1) an die Verbindungsleitung (ESL) zwischen Eingangs-Anschlußpunkt (EP; EP1, EP2,...) und Funktionslogik (FL) angeschaltet ist und der zweite Eingang (B1) an einen Test-Dateneingang (TDI) oder bei den weiteren Eingangs-Prüfstufen (EPS2, EPS3, ...) an den Datenausgang (DA1) der Speicherstufe (FF1) der vorhergehenden Eingangs-Prüfstufe (EPS1, EPS2,...) angeschaltet ist,
und bei der zwischen der Funktionslogik (FL) und den Ausgangs-Anschlußpunkten (AP; AP1, AP2,...) jeweils eine Ausgangs-Prüfschaltung (APS; APS1, APS2,...) angeordnet ist, die einen Ausgangs-Multiplexer (MUX2) aufweist, der in die Verbindungsleitung (ASL) zum Ausgangs-Anschlußpunkt (AP) eingeschaltet ist,
**dadurch gekennzeichnet,**
daß dem zweiten Eingang (DE2) des Ausgangs-Multiplexers (MUX2) eine Ausgangs-Speicherstufe (FF2) vorgeschaltet ist,
deren Dateneingang (DE2) an den Datenausgang (DA2) der letzten Eingangs-Prüfstufe (EPSn) oder bei den weiteren Ausgangs-Prüfstufen (APS2, APS3,...) an den Datenausgang (DA2; DA21, DA22,...) der vorhergehenden Ausgangs-Prüfstufe (APS1, APS2,...) angeschaltet ist,
und daß getrennte Steuerleitungen (ST1, ST2) für die Eingangs-Multiplexer (MUX1) und die Ausgangs-Multiplexer (MUX2) auf Anschlußpunkte der integrierten Schaltung (IC) herausgeführt sind.

2.   Prüfbare integrierte Schaltung (ICT), die bidirektionale Anschlußpunkte (BP) aufweist und bei der zwischen den Anschlußpunkten (BP) und der Funktionslogik (FL) Prüfstufen (BPS) vorgesehen sind, die einen Eingangsteil (ET) und einen Ausgangsteil (AT) aufweisen, die mit Multiplexern und getakteten Speicherstufen realisiert sind,
und deren Eingangsteile (ET) und Ausgangsteile (AT) in Kette geschaltet sind,
**dadurch gekennzeichnet**,
daß der Anschlußpunkt (BP) an eine Eingangsleitung (ESL) der Funktionslogik (FS) geführt ist,
daß in jeder Prüfstufe (BPS) der Anschlußpunkt (BP) im Eingangsteil (ET) auf einen ersten Eingang (A1) eines Eingangs-Multiplexers (MUX1) geführt ist, dessen Ausgang mit einer ersten Speicherstufe (FF1) verbunden ist, deren Ausgang einen Datenausgang (DA1) bildet,

daß der zweite Eingang (B1) des Eingangs-Multiplexers (MUX1) an den Datenausgang (DA1) des Eingangsteils (ET) der vorhergehenden Eingangs-Prüfstufe (EPS) bzw. an den Testdateneingang (TDE) angeschaltet ist;

daß im Ausgangsteil (AT) eine Ausgangsleitung (ASL) der Funktionslogik (FL) über einen ersten Eingang (A3) eines Ausgangs-Multiplexers (MUX3) und über eine Tri-State-Stufe (TB) auf den Anschlußpunkt (BP) geführt ist,

daß eine Ausgangs-Speicherstufe (FF2) vorgesehen ist, die einen Dateneingang (DE2) und einen Datenausgang (DA2) aufweist, der auf einen zweiten Eingang (B2) des Ausgangs-Multiplexers (MUX2) geführt ist, daß eine gemeinsame Steuerleitung (ST1) für die Eingangs-Multiplexer (MUX1) aller Eingangsteile auf einen Anschlußpunkt (ME1) der integrierten Schaltung (IC) herausgeführt ist, und zwei weitere Steuerleitungen (ST2, ST3) auf Anschlußpunkte (ME2, ME3) der integrierten Schaltung (IC) herausgeführt sind, die über einen Steuerteil (MUX3) die Richtungsumschaltung für Eingangsdaten (ED) und Ausgangsdaten (AD) ermöglichen.

3. Prüfbare integrierte Schaltung nach Anspruch 1 und 2,
**dadurch gekennzeichnet**,
daß bidirektionale Prüfstufen (BPS), Eingangs-Prüfstufen (EPS) oder/und Ausgangs-Prüfstufen (APS) in einem Baustein vorgesehen sind und in Kette schaltbar sind.

4. Prüfbare Schaltungsbaugruppe (BG) mit mindestens einer integrierten Schaltung (IC), bei der zwischen Eingangs-Anschlußpunkten (EP1, EP2, ...) und Funktionslogik (FL) jeweils eine Eingangs-Prüfstufe (EPS; EPS1, EPS2,...) angeordnet ist, die einen Eingang-Multiplexer (MUX1) und eine nachgeschaltete Eingangs-Speicherstufe (FF1) aufweist, wobei der erste Eingang (A1) des Eingangs-Multiplexers (MUX1) an die Verbindungsleitung (ESL) zwischen Eingangs-Anschlußpunkt (EP; EP1, EP2,...) und Funktionslogik (FL) angeschaltet ist und der zweite Eingang (B1) an einen Test-Dateneingang (TDI) oder bei den weiteren Eingangs-Prüfstufen (EPS2, EPS3, ...) an den Datenausgang (DA1) der Speicherstufe (FF1) der vorhergehenden Eingangs-Prüfstufe (EPS1, EPS2,...) angeschaltet ist, und bei der zwischen der Funktionslogik (FL) und den Ausgangs-Anschlußpunkten (AP; AP1, AP2,...) jeweils eine Ausgangs-Prüfschaltung (APS; APS1, APS2,...) angeordnet ist, die einen Ausgangs-Multiplexer (MUX2) aufweist, der in die Verbindungsleitung (ASL) zum Anschlußpunkt (AP) eingeschaltet ist,
**dadurch gekennzeichnet**,
daß dem zweiten Eingang (DE2) des Ausgangs-Multiplexers (MUX2) eine Ausgangs-Speicherstufe (FF2) vorgeschaltet ist, deren Dateneingang (DE2) an den Datenausgang (DA2) der letzten Eingangs-Prüfstufe (EPSn) oder bei den weiteren Ausgangs-Prüfstufen (APS2, APS3,...) an den Datenausgang (DA2; DA21, DA22,...) der vorhergehenden Ausgangs-Prüfstufe (APS1, APS2,...) angeschaltet ist, und daß getrennte Steuerleitungen (ST1, ST2) für die Eingangs-Multiplexer (MUX1) und die Ausgangs-Multiplexer (MUX2) auf Anschlußpunkte der integrierten Schaltung (IC) herausgeführt sind.

5. Prüfbare Schaltungsbaugruppe (BG), insbesondere nach Anspruch 1,
mit mindestens einer integrierten Schaltung (ICT), die bidirektionale Anschlußpunkte (BP) aufweist und bei der zwischen den Anschlußpunkten (BP) und der Funktionslogik (FL) Prüfstufen (BPS) vorgesehen sind, die einen Eingangsteil (ET) und einen Ausgangsteil (AT) aufweisen, und mit Multiplexern und getakteten Speicherstufen realisiert sind, und deren Eingangsteile (ET) und Ausgangsteile (AT) in Kette geschaltet sind,
**dadurch gekennzeichnet**,
daß der Anschlußpunkt (BP) an eine Eingangsleitung (ESL) der Funktionslogik (FS) geführt ist,
daß in jeder Prüfstufe (BPS) der Anschlußpunkt (BP) im Eingangsteil (ET) auf einen ersten Eingang (A1) eines Eingangs-Multiplexers (MUX1) geführt ist, dessen Ausgang mit einer ersten Speicherstufe (FF1) verbunden ist, deren Ausgang einen Datenausgang (DA1) bildet, daß der zweite Eingang (B1) des Eingangs-Multiplexers (MUX1) an den Datenausgang (DA1) des Eingangsteils (ET) der vorhergehenden Eingangs-Prüfstufe (EPS) bzw. an den Testdateneingang (TDE) angeschaltet ist;
daß im Ausgangsteil (AT) eine Ausgangsleitung (ASL) der Funktionslogik (FL) über einen ersten Eingang (A3) eines Ausgangs-Multiplexers (MUX2) und über eine Tri-State-Stufe (TB) auf den Anschlußpunkt (BP) geführt ist,
daß eine Ausgangs-Speicherstufe (FF2) vorgesehen ist, die einen Dateneingang (DE2) und einen Datenausgang (DA2) aufweist, der auf einen zweiten Eingang (B2) des Ausgangs-Multiplexers (MUX2) geführt ist, daß eine gemeinsame Steuerleitung (ST1) für die Eingangs-Multiplexer (MUX1) aller Eingangsteile auf einen Anschlußpunkt (ME1) der integrierten Schaltung (IC) herausgeführt ist, und zwei weitere Steuerleitungen (ST2, ST3) auf Anschlußpunkte (ME2, ME3) der integrierten Schaltung (IC) für Eingangsdaten (ED) und Ausgangsdaten (AD) herausgeführt sind, die über einen Steuerteil die Richtungsumschaltung für Eingangsdaten (ED) und Ausgangsdaten (AD) ermöglichen.

6.  Prüfbare Baugruppe nach Anspruch 4 und Anspruch 5,
    **dadurch gekennzeichnet**,
    daß integrierte Schaltungen (IC1, IC2, IC3) vorgesehen sind, die bidirektionale Prüfstufen (BPS), Eingangs-Prüfstufen (EPS) oder/und Ausgangsprüfstufen (APS) aufweisen, die in Kette schaltbar sind.

7.  Prüfbare Baugruppe nach einem der Ansprüche 4 bis 6,
    **dadurch gekennzeichnet**,
    daß ein Controller (COT) vorgesehen ist, dem die Steuerinformation (MI) seriell zugeführt wird und diese in parallele Steuerinformation (MS1, MS2, MS3) umsetzt.

# FIG 1

# FIG 2

EP

ESL

ED

DE1

FL

TDI

B1

MUX1

FF1

DA1

A1

ED/TD1

ME1

ST1

MS1

EPS

TC

TE

# FIG 3

DE2
TDO

FL

ASL

AD

A2

BU

AD / TDO

AP

MUX 2

B2

TD

FF2

DA2

TC

MS2

APS

ME2

ST2

# FIG 4

FIG 5

FIG 7

FIG 6